# EUROPÄISCHE PATENTSCHRIFT

(11) **EP 2 705 602 B1**
(45) Veröffentlichungstag und Bekanntmachung des Hinweises auf die Patenterteilung: **07.06.2017**
(21) Anmeldenummer: 12718128.7
(22) Anmeldetag: 17.04.2012
(51) Int. Cl.: H03F 1/02, H03F 1/42, H01G 5/16, H01G 5/18

(54) **QUASI-BREITBANDIGER DOHERTY-VERSTÄRKER UND DIESBEZÜGLICHE KONDENSATORSCHALTUNG**
QUASI-BROADBAND DOHERTY AMPLIFIER AND ASSOCIATED CAPACITOR CIRCUIT
AMPLIFICATEUR DOHERTY QUASI À LARGE BANDE ET CIRCUIT DE CONDENSATEURS CORRESPONDANT

(30) Priorität: 05.05.2011 DE 102011075312
(43) Veröffentlichungstag der Anmeldung: 12.03.2014
(60) Teilanmeldung: 14156572.1
(73) Patentinhaber: Rohde & Schwarz GmbH & Co. KG, 81671 München (DE)
(72) Erfinder: SCHENK, Lothar, Berlin 12555 (DE)
(74) Vertreter: Körfer, Thomas
(86) Internationale Anmeldenummer: PCT/EP2012/056989
(87) Internationale Veröffentlichungsnummer: WO 2012/150126

(56) Entgegenhaltungen:
- EP-A1- 0 201 409
- EP-A1- 1 699 107
- EP-A2- 0 637 042
- WO-A1-2007/132061
- US-A1- 2007 008 032
- US-A1- 2007 070 576
- US-A1- 2009 102 553
- US-A1- 2009 146 765
- US-A1- 2011 169 590
- US-B1- 7 773 959
- DJOUMESSI ET AL: "Varactor-Tuned Dual-Band Quadrature Hybrid Coupler", IEEE MICROWAVE AND WIRELESS COMPONENTS LETTERS, IEEE SERVICE CENTER, NEW YORK, NY, US, Bd. 16, Nr. 11, 1. November 2006 (2006-11-01), Seiten 603-605, XP011149740, ISSN: 1531-1309, DOI: 10.1109/LMWC.2006.884905
- TAMOTSU NISHINO ET AL: "Tunable MEMS hybrid coupler and L-band tunable filter", MICROWAVE SYMPOSIUM DIGEST, 2009. MTT '09. IEEE MTT-S INTERNATIONAL, IEEE, PISCATAWAY, NJ, USA, 7. Juni 2009 (2009-06-07), Seiten 1045-1048, XP031490701, ISBN: 978-1-4244-2803-8
- FARDIN E A ET AL: "A Varactor Tuned Branch-Line Hybrid Coupler", MICROWAVE CONFERENCE PROCEEDINGS, 2005. APMC 2005. ASIA-PACIFIC CONFER ENCE PROCEEDINGS SUZHOU, CHINA 04-07 DEC. 2005, PISCATAWAY, NJ, USA,IEEE, Bd. 3, 4. Dezember 2005 (2005-12-04), Seiten 1-4, XP010902044, DOI: 10.1109/APMC.2005.1606546 ISBN: 978-0-7803-9433-9
- FERRERO F ET AL: "Compact quasi-lumped hybrid coupler tunable over large frequency band", ELECTRONICS LETTERS, IEE STEVENAGE, GB, Bd. 43, Nr. 19, 13. September 2007 (2007-09-13), Seiten 1030-1031, XP006029646, ISSN: 0013-5194, DOI: 10.1049/EL:20072195

## Beschreibung

Die Erfindung betrifft einen Verstärker, insbesondere einen Doherty-Verstärker. Um bei hohem Wirkungsgrad und hoher Linearität Hochfrequenzverstärker aufzubauen, werden herkömmlicherweise Doherty-Verstärker eingesetzt.

Aus dem europäischen Patent EP 1 609 239 B1 ist ein Doherty-Verstärker bekannt, welcher einen 3dB-Koppler gleichzeitig als Impedanztransformator für den Hauptverstärker und als Leistungskombinierer für den Haupt- und Hilfsverstärker einsetzt, indem das normalerweise mit dem Systemwellenwiderstand abgeschlossene entkoppelte Tor des 3dB-Kopplers mit einer kurzgeschlossenen oder leerlaufenden Leitung bestimmter Länge abgeschlossen wird. Die dort gezeigte Anordnung hat den Nachteil, dass ein Frequenzwechsel über die übliche Doherty-Bandbreite hinaus nicht möglich ist und der Platzbedarf für eine verlustarme Leitung relativ groß ist.

Das Dokument US7064606 offenbart einen Doherty Verstärker der über einen Isolationsanschluss verfügt. Am Isolationsanschluss ist durch einen kurzen Leitungslelement ein Kondensator verbunden. Das Dokument US 7,773,959 B1 zeigt einen Verstärker für I/Q-Signale. Ein I-Signal wird von ersten Verstärkern verstärkt, während ein Q-Signal von zweiten Verstärkern verstärkt wird. Die verstärkten I/Q-Signale werden einem Kombinierer zugeführt. Der Kombinierer kombiniert die Signale an einem Ausgangsanschluss. Der Kombinierer ist an einem Isolationsanschluss mit dem Abschluss versehen. Der Abschluss beinhaltet beispielsweise einen Kondensator und in Serie dazu einen Widerstand, welche mit einem Masseanschluss verbunden sind.

Das Dokument EP 1 699 107 A1 zeigt einen Koppler mit einem ersten und einem zweiten elektrischen Leiter, die voneinander beabstandet sind und die in einem Kopplungsbereich kapazitiv und induktiv miteinander gekoppelt sind.

Der Erfindung liegt die Aufgabe zugrunde, einen Hochfrequenzverstärker und eine diesbezügliche Kondensatorschaltung zu schaffen, welcher bei hohem Wirkungsgrad und hoher Linearität einen geringen Platzbedarf erfordert.

Die Aufgabe wird erfindungsgemäß für die Vorrichtung durch die Merkmale des unabhängigen Anspruchs 1 gelöst. Vorteilhafte Weiterbildungen sind Gegenstand der hierauf rückbezogenen Unteransprüche.

Ein erfindungsgemäßer Verstärker verfügt über eine erste Verstärkerschaltung, eine zweite Verstärkerschaltung, eine erste Hybridkopplerschaltung und einem Abschluss. Die Hybridkopplerschaltung verfügt über einen Ausgangsanschluss und einen Isolationsanschluss. Der Abschluss ist dabei mit dem Isolationsanschluss der Hybridkopplerschaltung verbunden. Der Abschluss umfasst einen ersten Kondensator und/oder eine Induktivität, welche unmittelbar an dem Insolationsanschluss der Hybridkopplerschaltung angeordnet ist. Der erste Kondensator und/oder die Induktivität sind dabei direkt ohne Zwischenschaltung eines Leitungselements oder nur mit einem Leitungselement, dessen Länge kleiner als 1/10 der kürzesten im Verstärker verwendeten Wellenlänge ist, mit dem Isolationsanschluss der Hybridkopplerschaltung verbunden. Der Abschluss beinhaltet weiterhin einen Schalter und einen Abschlusswiderstand. Der Schalter ist an seinem Eingangsanschluss mit dem Isolationsanschluss verbunden. Der Schalter ist an seinem ersten Ausgangsanschluss mit dem Abschlusswiderstand verbunden. Der Schalter ist an seinem zweiten Ausgangsanschluss mit dem ersten Kondensator und/oder der Induktivität verbunden. Es werden so ein hoher Wirkungsgrad und eine große Flexibilität des Einsatzes erreicht.

Die Erfindung basiert auf der Erkenntnis, dass die elektrischen Eigenschaften einer kurzgeschlossenen oder leerlaufenden Leitung bestimmter Länge durch diskrete Elemente nachgebildet werden können. Statt der relativ platzintensiven Leitungsstruktur kann ein Kondensator oder eine Induktivität eingesetzt werden. Anstatt einen für den Abschluss benötigten Wellenwiderstand mittels eines Kurzschlusses oder Leerlaufs zu erzeugen, welcher mittels einer Leitung an den Isolationsanschluss transformiert wird, wird erfindungsgemäß der benötigte Wellenwiderstand direkt am Isolationsanschluss mittels eines diskreten Kondensators und/oder einer diskreten Induktivität erzeugt. Der Platzbedarf der Schaltung lässt sich so drastisch reduzieren.

Vorzugsweise ist der Kondensator oder die Induktivität einstellbar. Der Frequenzbereich des Verstärkers kann so einfach eingestellt werden.

Ein Quasi-breitbandiges System kann erreicht werden, wenn die Einstellung automatisch, d.h. z.B. mittels eines Servomotors erfolgt. In Systemen, bei welchen Frequenzwechsel nur relativ selten notwendig sind und der Verstärker gleichzeitig nur bei einem Frequenzbereich arbeitet, kann der Verstärker so in einem sehr breiten Frequenzbereich eingesetzt werden.

Vorzugsweise kann zusätzlich zwischen dem Kondensator bzw. der Induktivität und einem Abschluss mittels eines 500hm - Widerstands umgeschaltet werden. Es ist so möglich zwischen einem Breitbandverstärker herkömmlicher Bauart mit relativ schlechtem Wirkungsgrad und einem abstimmbaren Doherty-Verstärker mit relativ gutem Wirkungsgrad umzuschalten.

Nachfolgend wird die Erfindung anhand der Zeichnung, in der vorteilhafte Ausführungsbeispiele der Erfindung dargestellt sind, beispielhaft beschrieben. In der Zeichnung zeigen:
- Fig. 1: einen ersten exemplarischen Verstärker;
- Fig. 2: einen zweiten exemplarischen Verstärker;
- Fig. 3: ein erstes Ausführungsbeispiel des erfindungsgemäßen Verstärkers;
- Fig. 4: einen dritten exemplarischen Verstärker;
- Fig. 5: einen vierten exemplarischen Verstärker;
- Fig. 6a: ein zweites Ausführungsbeispiel des erfindungsgemäßen Verstärkers in einem ersten Schaltzustand;
- Fig. 6b: das zweite Ausführungsbeispiel des erfindungsgemäßen Verstärkers in einem zweiten Schaltzustand;
- Fig. 7: eine Detailansicht des zweiten Ausführungsbeispiels des erfindungsgemäßen Verstärkers;
- Fig. 8: eine erste exemplarische Kondensatorschaltung in einem ersten Zustand;
- Fig. 9: die erste exemplarische Kondensatorschaltung in einem zweiten Zustand;
- Fig. 10: eine zweite exemplarische Kondensatorschaltung in einer ersten Ansicht in einem ersten Zustand;
- Fig. 11: die zweite exemplarische Kondensatorschaltung in einer zweiten Ansicht in dem ersten Zustand;
- Fig. 12: die zweite exemplarische Kondensatorschaltung in einem zweiten Zustand;
- Fig. 13: eine dritte exemplarische Kondensatorschaltung in einem ersten Zustand in einer ersten Ansicht;
- Fig. 14: die dritte exemplarische Kondensatorschaltung in einem zweiten Zustand, und
- Fig. 15: die dritte exemplarische Kondensatorschaltung in dem ersten Zustand in einer zweiten Ansicht.

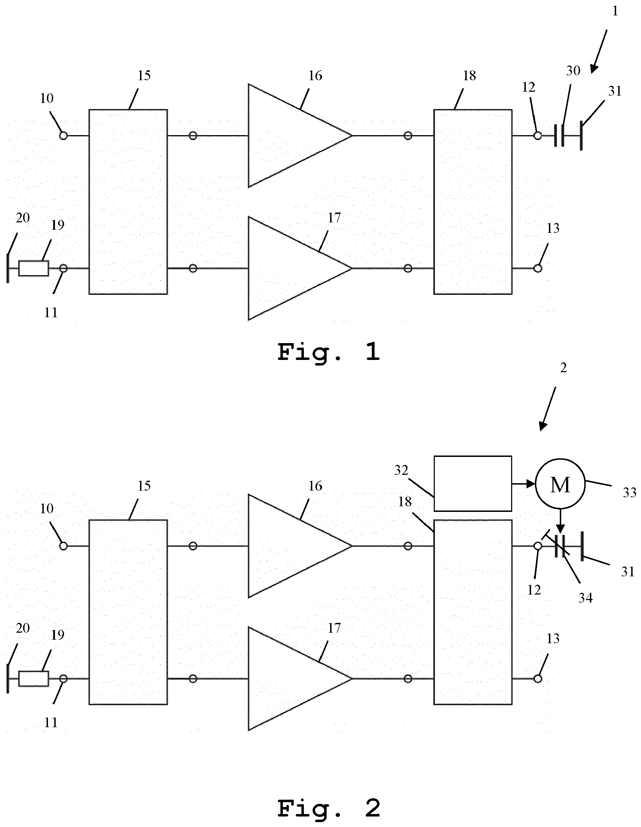

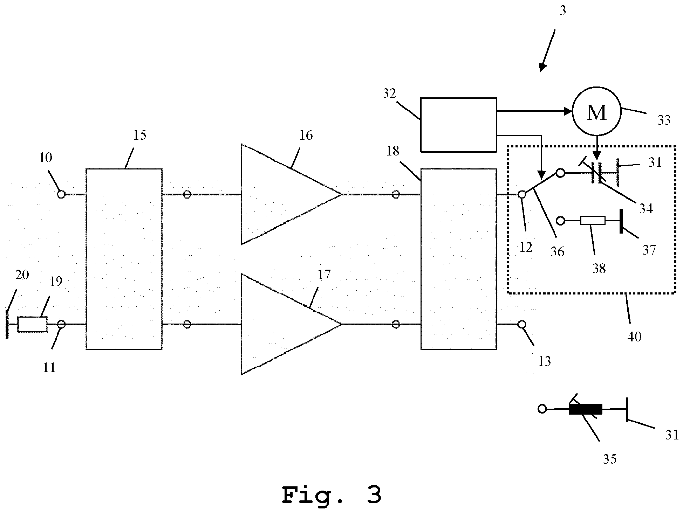

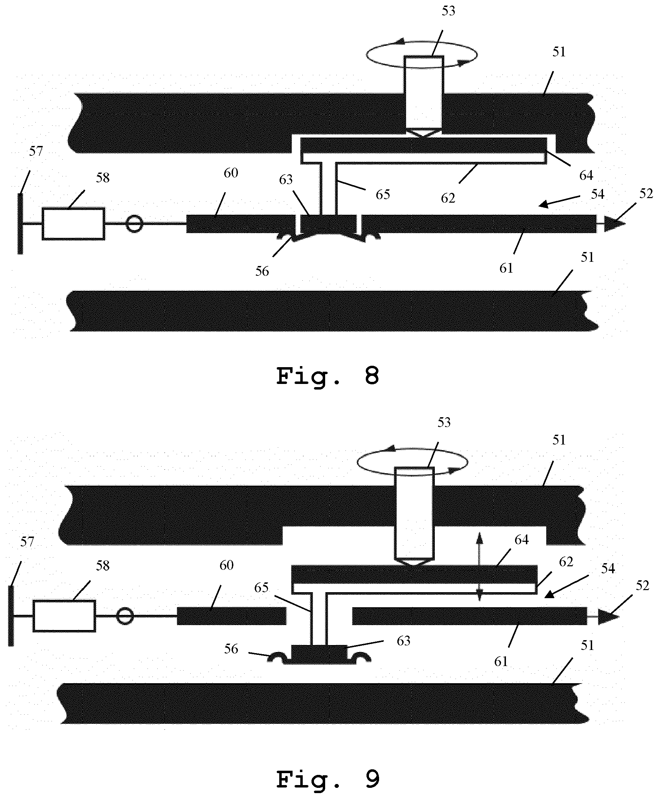

Zunächst wird anhand der Fig. 1 - 7 der Aufbau und die Funktionsweise verschiedener Verstärker erläutert. Insbesondere wird anhand von Fig. 3 und Fig. 6a - 7 auf den Aufbau und die Funktionsweise des erfindungsgemäßen Verstärkers eingegangen. Anschließend wird anhand von Fig. 8 - 15 auf den Aufbau und die Funktionsweise verschiedener Formen einer exemplarischen Kondensatorschaltung eingegangen. Identische Elemente werden in ähnlichen Abbildungen z.T. nicht wiederholt dargestellt und beschrieben.

Fig. 1 zeigt einen ersten exemplarischen Verstärker. Ein Leistungsteiler 15 verfügt über zwei Eingangsanschlüsse 10 und 11. An dem ersten Eingangseinschluss 10 kann ein Eingangssignal eingespeist werden. Der zweite Eingangsanschluss 11 ist mit einem Widerstand 19 und einem Masseanschluss 20 abgeschlossen. An den Leistungsteiler 15 sind weiterhin eine erste Verstärkerschaltung 16 und eine zweite Verstärkerschaltung 17 angeschlossen. Diese bilden den Hauptverstärker und den Hilfsverstärker gemäß dem Doherty-Prinzip. Ausgänge dieser Verstärkerschaltungen 16, 17 sind mit einer Hybridkopplerschaltung 18 verbunden. Ein Isolationsanschluss 12 dieser Hybridkopplerschaltung 18 ist mit einem diskreten Kondensator 30 und einem Masseanschluss 31 abgeschlossen. Der Kondensator 30 und der Masseanschluss 31 bilden dabei einen Abschluss 1.

Das zu verstärkende Signal wird dem Eingangsanschluss 10 des Leistungsteilers 15 zugeführt. Dieser teilt das Signal auf die beiden Verstärkerschaltungen 16, 17 auf, welche das Signal gemäß dem Doherty-Prinzip verstärken. Die verstärkten Signale werden von der Hybridkopplerschaltung 18 an ihrem Ausgangsanschluss 13 kombiniert. Durch den Kondensator 30 und den Masseanschluss 31 an dem Isolationsanschluss 12 der Hybridkopplerschaltung 18 wird ein optimaler Abschluss der Hybridkopplerschaltung 18 bei einer gegebenen Frequenz erreicht. Gleichzeitig wird ein sehr geringer Bauraum benötigt.

Eine weitere vorteilhafte Ausgestaltung ist, die erste Verstärkerschaltung 16 und die zweite Verstärkerschaltung 17 im System zu tauschen. So entsteht ein Doherty-Verstärker, der bei einer anderen Frequenz invers arbeitet. Ist die Arbeitspunktsteuerung in der Lage, die Konfiguration zu wechseln, ist die nutzbare Bandbreite des Systems verdoppelt. Es entsteht allerdings nicht unbedingt ein zusammenhängender Frequenzbereich.

Fig. 2 zeigt einen zweiten exemplarischen Verstärker. Die Schaltung entspricht weitgehend der Schaltung aus Fig. 1. Der diskrete und in seiner Kapazität feste Kondensator 30 aus Fig. 1 ist hier durch einen einstellbaren Kondensator 34 ersetzt. Die Kapazität dieses Kondensators 34 kann durch einen Servomotor 33, welcher von einer Steuereinrichtung 32 gesteuert wird, eingestellt werden. Der Kondensator 34, der Masseanschluss 31, der Servomotor 33 und die Steuereinrichtung 32 bilden dabei einen Abschluss 2.

Es ist so möglich, die Frequenz, für welche die Hybridkopplerschaltung 18 optimal abgeschlossen ist, einzustellen. Da der Verstärker gleichzeitig lediglich auf einer Frequenz arbeitet, ist es unproblematisch, dass die Einstellung des einstellbaren Kondensators 34 durch den Servomotor 33 eine gewisse Zeit in Anspruch nimmt.

Fig. 3 zeigt ein erste Ausführungsbeispiel des erfindungsgemäßen Verstärkers. Auch diese Darstellung entspricht weitgehend der Darstellung aus Fig. 1. Zusätzlich ist hier der Ausgangsanschluss 12 der Hybridkopplerschaltung 18 mit einem Schalter 36 verbunden. Der Schalter 36 schaltet zwischen dem einstellbaren Kondensator 34 aus Fig. 2 und einem ohmschen Abschlusswiderstand 38 in Serie mit einem Masseanschluss 37 um. Der Kondensator 34, der Masseanschluss 31, der Servomotor 33, die Steuereinrichtung 32, der Schalter 36, der ohmsche Widerstand 38 und der Masseanschluss 37 bilden dabei einen Abschluss 3.

Es wird so erreicht, dass zwischen einem Betrieb als Doherty-Verstärker und einem Betrieb als herkömmlichem breitbandigem Verstärker umgeschaltet werden kann. Zusätzlich zu der Umschaltung mittels des Schalters 36 müssen die Arbeitspunkte der Verstärkerschaltungen 16 und 17 angepasst werden. Der Schalter 36 wird dabei zusätzlich von der Steuereinrichtung 32 aus Fig. 2 gesteuert. Ein manuelles Eingreifen ist somit nicht notwendig.

Die Kombination aus dem Schalter 36, dem einstellbaren Kondensator 34 und dem alternativ anschaltbaren ohmschen Widerstand 38 bildet dabei eine Kondensatorschaltung 40. Die folgenden Figuren zeigen mögliche Ausgestaltung einer solchen Kondensatorschaltung. Alternativ kann wie unten dargestellt der einstellbare Kondensator 34 auch durch eine einstellbare Induktivität 35 ersetzt werden.

Alternativ können auch anstatt des Motors 33 und des einstellbaren Kondensators 34 ein Schalter 36 mit mehreren Kondensatoren fester Kapazität eingesetzt werden. Die Umschaltung erfolgt dann zwischen dem ohmschen Widerstand 38 und mehreren festen Kapazitäten. Auch ein Verzicht auf den Schalter 36 und die Steuereinrichtung 32 ist denkbar. In diesem Fall ist der Anschluss 12 über eine Lötbrücke mit dem ohmschen Widerstand 38 oder einem Kondensator verbunden.

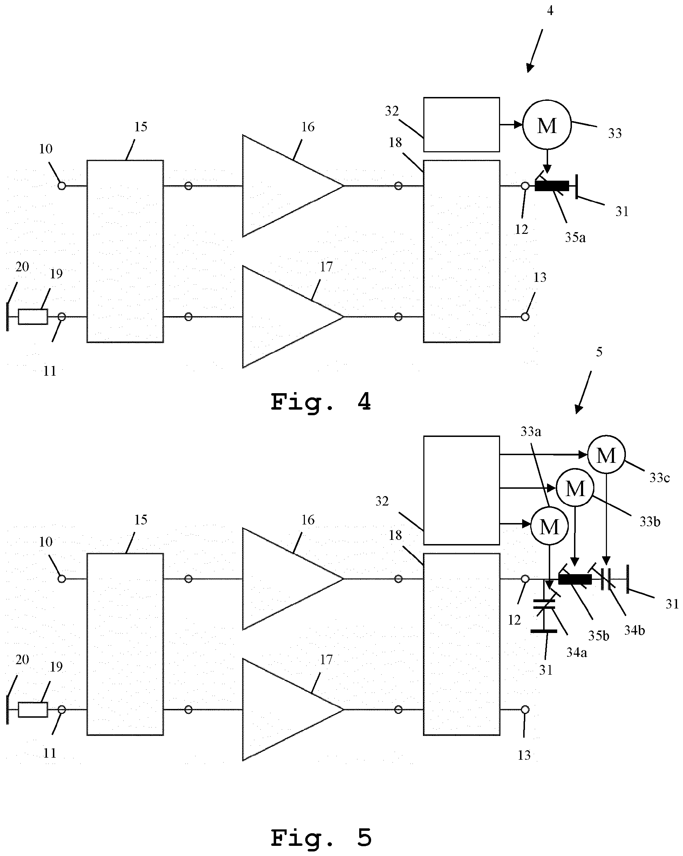

Fig. 4 zeigt einen drittenexemplarischen Verstärker. Dieser Verstärker entspricht weitgehend dem Verstärker aus Fig. 2. Der einstellbare Kondensator 24 wurde hier jedoch durch eine einstellbare Induktivität 35a ersetzt.

In Fig. 5 wird ein vierter exemplarischer Verstärker gezeigt. Dieser Verstärker entspricht zum Teil dem Verstärker aus Fig. 2. Hier wurde der einstellbare Kondensator 34 durch einen ersten einstellbaren Kondensator 34a geschaltet gegen Masse 31, eine einstellbare Induktivität 35b und einen zweiten einstellbaren Kondensators 34b geschaltet gegen Masse 31 ersetzt. Diese werden jeweils durch einen eigenen Servomotor 33a, 33b und 33c eingestellt. Die Servomotoren 33a, 33b und 33c werden von der Steuereinrichtung 32 gesteuert. Durch diese Konfiguration kann eine noch größere Bandbreite des Verstärkers realisiert werden. Eine einfachere Realisierung kann erreicht werden, indem die Induktivität nicht einstellbar gewählt wird. Die Komplexität kann weiter reduziert werden, indem die beiden Einstellbaren Kondensatoren 34a und 34b synchron eingestellt werden.

Anstatt der Umschaltung zwischen verschiedenen Bauelementen mittels eines elektrisch gesteuerten Schalters 36, wie er in Fig. 3 dargestellt ist, ist auch der Einsatz eines manuell zu betätigenden Schalters möglich. Auch ist die Umschaltung zwischen Bauelementen, welche in den übrigen Figuren dargestellt sind, möglich. Im Folgenden wird ein Ausführungsbeispiel dargestellt, in welchem eine Umschaltung zwischen einem ohmschen Wiederstand, wie er in Fig. 3 dargestellt ist und einem π-Glied, wie es in Fig. 5 dargestellt ist.

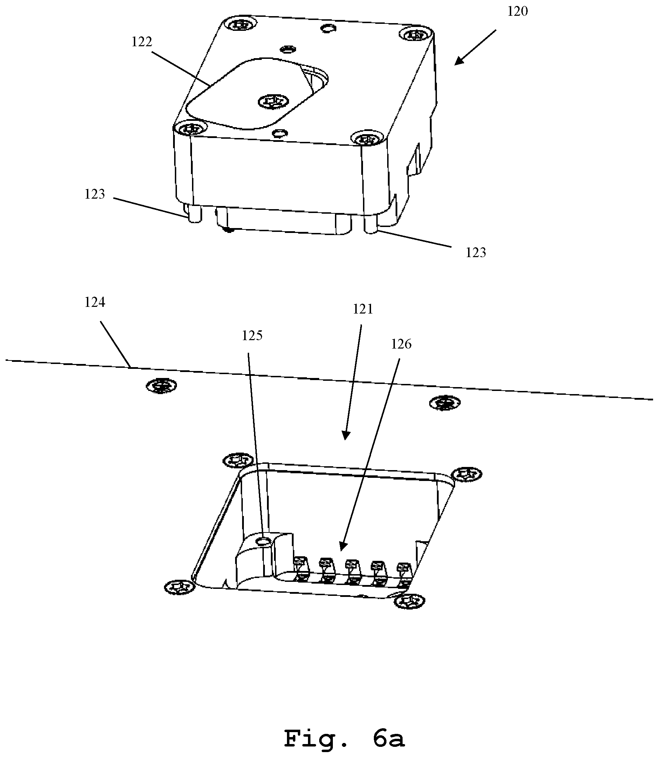

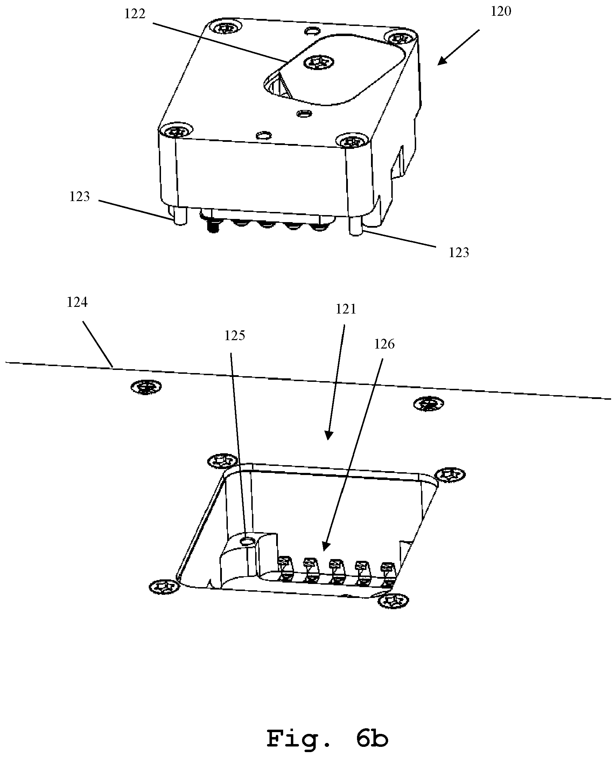

In Fig. 6a und Fig. 6b wird ein zweites Ausführungsbeispiel des erfindungsgemäßen Verstärkers gezeigt. Der Verstärker weist hier ein Verstärkergehäuse 124 und ein Einsteckmodul 120 auf. Das Verstärkergehäuse 124 beinhaltet sämtliche Bauelemente des Verstärkers mit Ausnahme zumindest eines Teils der am Isolationsanschluss angeschlossenen Bauelemente. Das Einsteckmodul 120 beinhaltet zumindest einen Teil der am Isolationsanschluss anzuschließenden Bauelemente. Das Verstärkergehäuse 124 verfügt über eine Ausnehmung 121 zur Aufnahme des Einsteckmoduls 120.

Das Einsteckmodul 120 verfügt dabei über Führungsstifte 123, welche beim Einstecken des Einsteckmoduls 120 in die Ausnehmung 121 des Verstärkergehäuses 124 in Führungen 125 greifen und somit die Positionierung des Einsteckmoduls 120 in den Verstärkergehäuse 124 mit einer hohen Präzision ermöglichen.

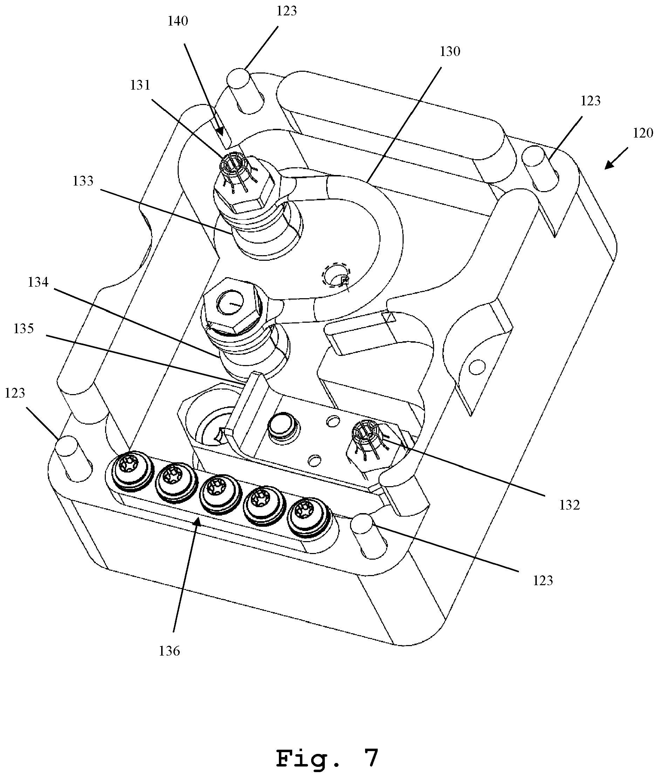

In der Ausnehmung 121 des Verstärkergehäuses 124 sind zusätzlich Federkontakte 126 zur Kontaktierung des Einsteckmoduls 120 angeordnet. Auf die Funktion der Federkontakte 126 wird anhand von Fig. 7 näher eingegangen. Das Einsteckmodul 120 verfügt darüber hinaus über einen entfernbaren Deckel 122. Wird der Deckel 122 entfernt, so können durch diese Öffnung abstimmbare Schaltungselemente abgestimmt werden. Auch auf diese Elemente wird anhand von Fig. 7 näher eingegangen.

Das Einsteckmodul 120 ist dabei derart ausgestaltet, dass es in verschiedenen Orientierungen in die Ausnehmung 121 eingesetzt werden kann. In Fig. 6a ist eine erste Orientierung des Einsteckmoduls 120 gegenüber der Ausnehmung 121 dargestellt. In Fig. 6b ist eine zweite Orientierung des Einsteckmoduls 120 gegenüber der Ausnehmung 121 dargestellt. Das Einstecken des Einsteckmoduls 120 in die Ausnehmung 121 in den verschiedenen Orientierungen bewirkt eine Verbindung unterschiedlicher Bauelemente innerhalb des Einsteckmoduls 120 mit dem übrigen Verstärker innerhalb des Verstärkergehäuses 124. D.h. das Einstecken in unterschiedlichen Orientierungen erfüllt die Funktion des Umschaltens zwischen verschiedenen angeschlossenen Bauelementen. Auch hierauf wird anhand von Fig. 7 näher eingegangen.

In Fig. 7 ist eine Detailansicht des zweiten Ausführungsbeispiels des erfindungsgemäßen Verstärkers gezeigt. Fig. 7 zeigt die der Darstellung in Fig. 6a und 6b gegenüberliegende Seite des Einsteckmoduls 120. Auch hier sind die Führungsstifte 123 deutlich erkennbar. Das Einsteckmodul 120 beinhaltet ein n-Glied 140, welches aus zwei einstellbaren Kondensatoren 133, 134 und einer Induktivität 130 gebildet ist. Bei den hier dargestellten Kondensatoren 133, 134 handelt es sich um einstellbare Zylinderkondensatoren. Durch den in Fig. 6a und 6b dargestellten Deckel 122, welcher auf der Unterseite des in Fig. 7 dargestellten Einsteckmoduls 120 angeordnet ist, können die Kapazitäten der Zylinderkondensatoren 133, 134 durch Schrauben abgestimmt werden. Auch der Einsatz anderer einstellbarer Elemente ist hier denkbar. Statt eines n-Glieds 140 könnte alternativ auch lediglich ein einzelner einstellbarer Kondensator oder ein beliebiges der in Fig. 1 - 5 dargestellten, mit dem Anschluss 12 verbundenen Elemente eingesetzt werden.

Mit einem ersten Anschluss des ersten Kondensators 133 ist zusätzlich ein Buchsenkontakt 131 verbunden. Mit diesem ersten Anschluss ist weiterhin die Induktivität 130 verbunden. Die Induktivität 130 wird hier durch eine halbe Wicklung, d.h. einen 180°-Drahtbogen, gebildet. Die Induktivität 130 verbindet den ersten Anschluss des ersten Kondensators 133 mit einem ersten Anschluss des zweiten Kondensators 134. Die jeweils zweiten Anschlüsse der Kondensatoren sind mit dem Gehäuse, d.h. mit Masse, verbunden.

Darüber hinaus beinhaltet das Einsteckmodul 120 einen zweiten Buchsenkontakt 132, welcher mit einer Kontaktbrücke 135 verbunden ist. Die Kontaktbrücke 135 ist dabei derart ausgebildet, dass sie bei einem Einführen des Einsteckmoduls 120 in die Ausnehmung 121 des Verstärkergehäuses 124 in einer ersten Orientierung eine Verbindung zu einer im Verstärkergehäuse 124 angeordneten 50 Ohm-Last herstellt. In dieser Orientierung stellt die Anschlussbuchse 132 direkt Kontakt zu dem Ausgang 12 des Verstärkers her. D.h. in dieser Orientierung verbindet die Kontaktbrücke 135 den Anschluss 12 des Verstärkers mit einer 50 Ohm-Last. Bezogen auf Fig. 3 entspricht dies der unteren Schalterstellung des Schalters 36. Diese erste Ausrichtung des Einsteckmoduls 120 entspricht somit dem herkömmlichen AB-Betrieb des Verstärkers.

Wird das Einsteckmodul 120 jedoch in der zweiten Ausrichtung in die Ausnehmung 121 des Verstärkergehäuses 124 eingesetzt, stellt die Kontaktbuchse 131 Kontakt zu dem Anschluss 12 her. Somit ist der Anschluss 12 mit dem n-Glied 140 verbunden. Diese zweite Ausrichtung des Einsteckmoduls 120 entspricht somit einer Verbindung eines n-Glieds, wie es in Fig. 5 dargestellt ist, mit dem Anschluss 12 des Verstärkers. Eine solche Verbindung entspricht dem Doherty-Betrieb des Verstärkers.

Zusätzlich verfügt das Einsteckmodul 120 über mehrere Kodierungsschrauben 136. Diese sind derart auf dem Einsteckmodul 120 angeordnet, dass sie bei Einführen des Einsteckmoduls 120 in die Ausnehmung 121 Kontakt zu den Federkontakten 126 herstellen. Die Federkontakte 126 sind dabei lediglich auf einer der beiden gegenüberliegenden Seiten der Ausnehmung 121 angeordnet, um lediglich bei der zweiten Ausrichtung des Einsteckmoduls 120, d.h. bei Betrieb des Verstärkers als Doherty-Verstärker Kontakt zu den Kodierungsschrauben aufnehmen zu können.

Durch die Anwesenheit der Kodierungsschrauben wird der jeweilige darunter befindliche Federkontakt 126 geschlossen. Die Federkontakte 126 sind dabei derart mit einer Steuereinrichtung verbunden, dass diese den Schaltzustand jedes einzelnen Federkontakts 126 kennt. Die Kodierungsschrauben 136 können einzeln eingeschraubt oder herausgeschraubt werden. Auch können sie einzeln entfernt werden. Das Bit-Muster, welches durch die Anwesenheit bzw. Abwesenheit der einzelnen Schrauben oder die Einschraubhöhe der einzelnen Schrauben gebildet wird, kodiert dabei die gegenwärtig eingestellte Abstimmungsfrequenz des π-Glieds 140. D.h. bei Einstellung eines Frequenzbereichs für den Doherty-Betrieb des erfindungsgemäßen Verstärkers wird zusätzlich manuell die eingestellte Frequenz als Bit-Muster in den Kodierungsschrauben 136 abgebildet. Der Verstärker erkennt somit über die Federkontakte 126, auf welche Frequenz das π-Glied 140 eingestellt ist.

Über die 5 dargestellten Kodierungsschrauben 136 sind prinzipiell 32 einstellbare Kanäle, d.h. 32 Kanäle denkbar. In der Praxis wird hier mit beispielsweise 12 Kanälen im UHF-Bereich gearbeitet. Bei jeder einzelnen Einstellung arbeitet das System dabei auf 3-4 Kanälen optimal und in den jeweils benachbarten Kanälen akzeptabel. Durch entsprechende Abstimmung lässt sich der Verstärker im Doherty-Modus im gesamten Frequenzbereich zwischen 470 und 862 MHz nutzen. Dabei gibt es 7 Standardabstimmungen die den gesamten Frequenzbereich abdecken. Die Standardabstimmungen können darüber hinaus auch auf bestimmte Kanäle innerhalb ihres Abstimmbereichs optimiert werden.

Die Fig. 8 und 9 zeigen eine erste exemplarische Kondensatorschaltung. An einem Anschluss 52, welcher dem Ausgangsanschluss 12 aus Fig. 1 - 5 entspricht, ist eine erste Kondensatorplatte 61 angeschlossen. Diese bildet zusammen mit einer zweiten Kondensatorplatte 64 einen Kondensator 54. Die zweite Kondensatorplatte 64 ist dabei mit einer motorgetriebenen Spindel 53 verbunden. Der Abstand der zweiten Kondensatorplatte 64 von der ersten Kondensatorplatte 61 wird mittels der motorgetriebenen Spindel 53 eingestellt. Die motorgetriebene Spindel 53 wird dabei von einem Servomotor angetrieben. Alternativ ist auch der Einsatz einer handgetriebenen Spindel möglich.

Verbunden mit der zweiten Kondensatorplatte 64 ist eine Isolatorplatte 62, welche einen Träger 65 aufweist. Der Träger 65 wiederum ist mit einem Leiterabschnitt 63 verbunden, welcher mit einem Schaltanschluss 56 verbunden ist. Mittels des Schaltanschlusses 56 kann die erste Kondensatorplatte 61 mit einem Leiterabschnitt 60 verbunden werden. Der Leiterabschnitt 60 wiederum ist mit einem Abschlusswiderstand 58 und einem Masseanschluss 57 verbunden. Der Kondensator 54 entspricht hier dem einstellbaren Kondensator 34 aus Fig. 2 - 3. Der Schaltanschluss 56 entspricht hier dem Schalter 36 aus Fig. 2 - 3. Der Abschlusswiderstand 58 und der Masseanschluss 57 entsprechen hier dem Abschlusswiderstand 38 und dem Masseanschluss 37 aus Fig. 3.

In Fig. 8 ist ein erster Zustand der Kondensatorschaltung gezeigt. Die motorgetriebene Spindel 53 hat die zweite Kondensatorplatte 64 auf einen maximalen Abstand von der ersten Kondensatorplatte 61 gebracht. Die Isolatorplatte 62 und der Träger 65 ziehen den Leiterabschnitt 63 und damit auch den Schaltabschluss 56, welcher hier als Kontaktfeder realisiert ist, an die erste Kondensatorplatte 61 und den Leiterabschnitt 60. Die erste Kondensatorplatte 61, der Schaltanschluss 56, der Leiterabschnitt 63 und der Leiterabschnitt 60 sind somit elektrisch miteinander verbunden. Der Anschluss 52 ist somit elektrisch mit dem Abschlusswiderstand 58 und über diesen mit dem Masseanschluss 57 verbunden. Dies entspricht der unteren Schalterstellung des Schalters 36 aus Fig. 3.

In Fig. 9 ist ein zweiter Zustand der Kondensatorschaltung gezeigt. Die motorgetriebene Spindel 53 hat die zweite Kondensatorplatte 54 und damit auch die Isolatorplatte 62, den Träger 65, den Leiterabschnitt 63 und den Schaltanschluss 56 nach unten bewegt. Der Schaltanschluss 56 hat den Kontakt zu der ersten Kondensatorplatte 61 und den Leiterabschnitt 60 verloren. Dies entspricht der oberen Schalterstellung des Schalters 36 aus Fig. 3. Durch den Abstand zwischen der ersten Kondensatorplatte 61 und der zweiten Kondensatorplatte 64 wird die Kapazität des Kondensators 54 eingestellt. D.h. es wird an die Betriebsfrequenz des Verstärkers, in welchem diese Kondensatorschaltung eingesetzt werden kann, so angepasst.

Da die Isolatorplatte 62 und der Träger 65 aus einem nichtleitenden Material bestehen, beeinflussen Sie den Feldverlauf des Kondensators 54 nur unwesentlich. Durch Fertigung der Isolatorplatte 62 und des Trägers 65 aus einem Material, welches eine ähnliche Dielektrizitätskonstante aufweist wie das umgebende Medium, z.B. Luft, kann der Einfluss weiter reduziert werden.

In der in Fig. 8 gezeigten Schalterstellung wirkt die erste Kondensatorplatte 61 lediglich als Leiter, welcher den Anschluss 52 mit dem Abschlusswiderstand 58 verbindet. Der Abstand zu der zweiten Kondensatorplatte 64 ist dabei so groß, dass kein nennenswerter Effekt auftritt. Die zweite Kondensatorplatte 54 liegt dabei über die motorgetriebene Spindel und das Gehäuse 51 auf Massepotential.

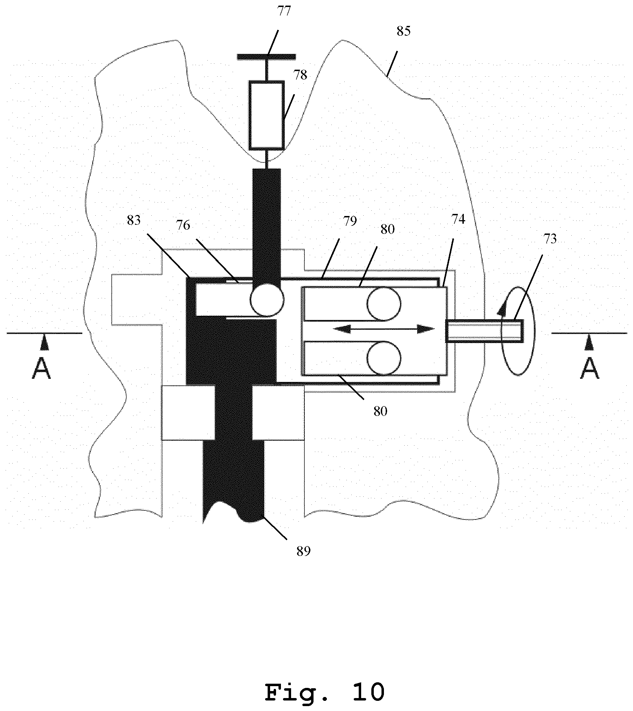

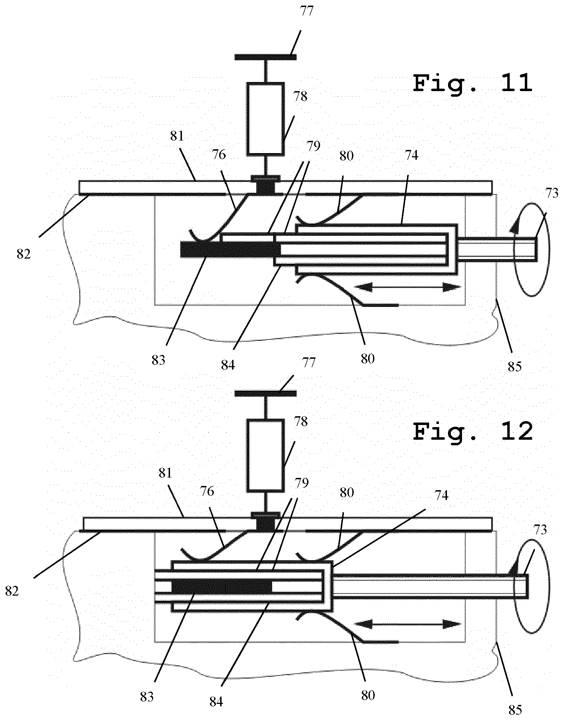

Fig. 10 - 12 zeigen eine zweite exemplarische Kondensatorschaltung. Die Ansicht der Fig. 11 und Fig. 12 entspricht dem Schnitt entlang der Schnittlinie A aus Fig. 10. Ein Gehäuse 85 liegt auf Massepotential. Das Gehäuse 85 ist auf einer Seite mittels einer Leiterplatte 81, welche auf ihrer Unterseite mit einer metallisierten Masselage 82 versehen ist, abgedeckt. In einer Aussparung des Gehäuses 85 ist ein Leiter 89 angeordnet. Dieser ist hier als Flachbandleiter realisiert. Das obere Ende des Leiters 89 ist dabei zu einer ersten Kondensatorplatte 83 ausgebildet.

In einem ersten Zustand, welcher in den Fig. 10 und Fig. 11 gezeigt ist, befindet sich die erste Kondensatorplatte 83 über einen Schaltanschluss 76, welcher hier als Kontaktfeder realisiert ist, in Verbindung mit einem Abschlusswiderstand 78 und einem Masseanschluss 77. Dies entspricht der unteren Schalterstellung aus Fig. 3. Der Leiter 89 steht an seinem unteren Ende dabei mit dem Isolationsanschluss des Verstärkers, in welchem die hier gezeigte Kondensatorschaltung eingesetzt ist, in Verbindung.

Eine motorgetriebene Spindel 73, welche beispielsweise von dem Servomotor 33 aus Fig. 3 angetrieben werden kann, ist mit einer zweiten Kondensatorplatte 74 verbunden. Die zweite Kondensatorplatte 74 ist mit einer Isolatorplatte 79 verbunden. Die Isolatorplatte 79 weist im Bereich des Schaltanschlusses 76 einen Vorsprung auf. Die zweite Kondensatorplatte 74 ist dabei derart ausgebildet, dass sie die erste Kondensatorplatte umfassen kann. Auf ihrer Oberseite wird sie dabei durch die erste Isolatorplatte 69 von der ersten Kondensatorplatte 83 getrennt. Auf ihrer Unterseite wird Sie dabei von einer zweiten Isolatorplatte 84, welche ebenfalls mit der zweiten Kondensatorplatte 74 verbunden ist, auf Abstand zu der ersten Kondensatorplatte 83 gehalten.

In einem ersten Zustand, welcher in Fig. 10 und Fig. 11 gezeigt ist, steht der Schaltanschluss 76 in Kontakt mit der ersten Kondensatorplatte 83. Es besteht somit eine leitende Verbindung dem Anschluss 82 und dem Abschlusswiderstand 78. In einem zweiten Zustand, welcher in Fig. 12 gezeigt ist, hat die motorgetriebene Spindel 73 die zweite Kondensatorplatte 74 und die erste und zweite Isolatorplatte 79, 84 in Richtung der ersten Kondensatorplatte 83 bewegt. Der Vorsprung der ersten Isolatorplatte 79 hat den Schaltanschluss 76 von der ersten Kondensatorplatte 83 abgehoben und so die elektrische Verbindung der Leitung 89 zu dem Abschlusswiderstand 78 unterbrochen. Gleichzeitig wurde die zweite Kondensatorplatte 74 um die erste Kondensatorplatte 83 gestülpt. Die Kapazität zwischen der ersten Kondensatorplatte 83 und der zweiten Kondensatorplatte 74 ist hierdurch signifikant angestiegen. Die zweite Kondensatorplatte 74 steht dabei in elektrischem Kontakt mit Kontaktfedern 80, welche einen Kontakt zu dem auf Massepotenzial befindlichen Gehäuse 85 herstellen. Über die genaue Positionierung der zweiten Kondensatorplatte 74 mittels der motorgetriebenen Spindel 73 kann die gewünschte Kapazität eingestellt werden. Eine Einstellung der Betriebsfrequenz des Verstärkers, in welchem die hier gezeigte Kondensatorschaltung eingesetzt werden soll, ist so möglich.

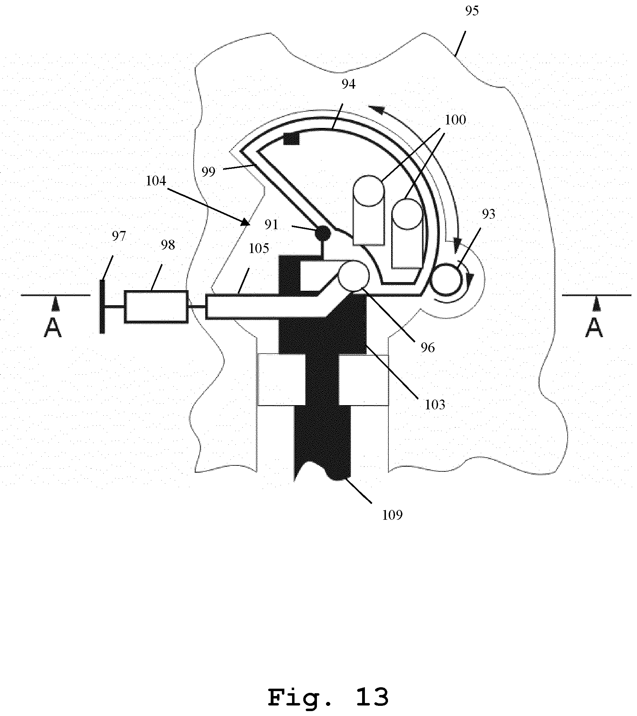

Die Fig. 13 - 15 zeigen eine weitere exemplarische Kondensatorschaltung. Zur Einstellung der Kapazität wird hier ein Drehkondensator eingesetzt. In einem auf Massepotenzial befindlichen Gehäuse 95 ist eine Ausnehmung 104 angeordnet. In die Ausnehmung 104 ragt das Ende einer Leitung 109, welche zu einer ersten Kondensatorplatte 103 verbreitert ist. In der Ausnehmung 104 ist weiterhin eine zweite Kondensatorplatte 94 angeordnet, welche um eine Drehachse 91 drehbar ist. Die zweite Kondensatorplatte 94 ist dabei derart ausgebildet, dass sie die ersten Kondensatorplatte 103 umfassen kann. Die zweite Kondensatorplatte 94 ist dabei mit einer Isolatorplatte 99 verbunden, welche ebenfalls so ausgelegt ist, dass sie die erste Kondensatorplatte 103 umfassen kann. Die Isolatorplatte 99 steht dabei in Kontakt mit einer motorgetriebenen Spindel 93. Mittels eines Reibrades oder eines Zahnrades greift die motorgetriebene Spindel 93 tangential am Umfang der Platte an und dreht die Isolatorplatte 99 und die zweite Kondensatorplatte 94 um die Drehachse 91. Alternativ ist ein Antrieb direkt durch die Drehachse 91 möglich. Es kann dann auf die motorgetriebene Spindel 93 verzichtet werden.

Ein Schaltanschluss 96, welcher hier als Kontaktfeder ausgeführt ist, ist mittels eines Leiterabschnitts 105 mit einem Abschlusswiderstand 98 und über diesen mit einem Masseanschluss 97 verbunden.

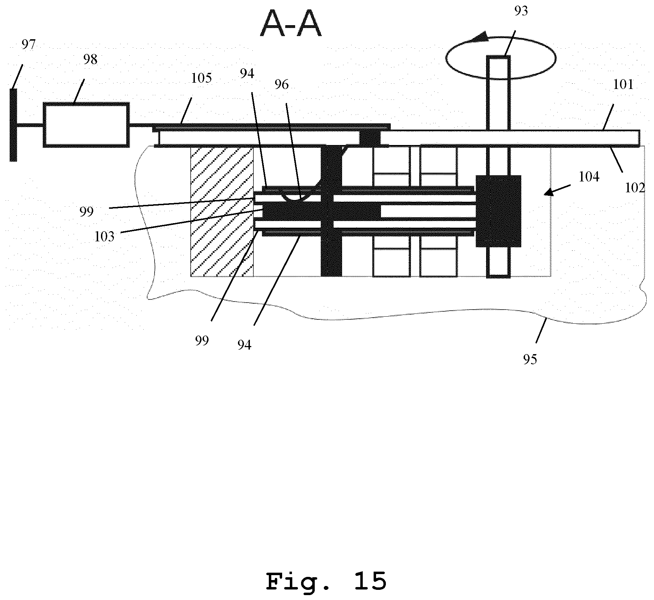

In einem ersten Zustand, welcher in Fig. 13 und Fig. 15 dargestellt ist, stellt der Schaltanschluss 96 einen Kontakt zwischen der ersten Kondensatorplatte und dem Leiterabschnitt 105 her. Die Leitung 109 ist somit elektrisch mit dem Abschlusswiderstand 98 und über diesen mit dem Masseanschluss 97 verbunden. Dies entspricht der unteren Schalterstellung aus Fig. 3.

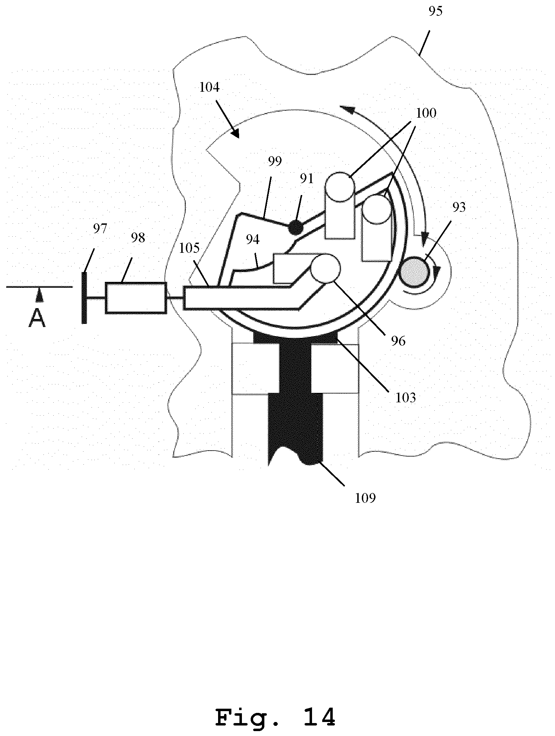

In einem zweiten Zustand, welcher in Fig. 14 dargestellt ist, ist die zweite Kondensatorplatte 94 und die Isolatorplatte 99 derart um die Drehachse 91 gedreht, dass die Isolatorplatte 99 und die zweite Kondensatorplatte 94 den Kontakt des Schaltanschlusses 96 zu der ersten Kondensatorplatte unterbrechen. Die zweite Kondensatorplatte 94 und die Isolatorplatte 99 umfassen nun die erste Kondensatorplatte 103. Die zweite Kondensatorplatte 94 steht über Kontaktfedern 100 in elektrischer Verbindung mit dem auf Massepotenzial befindlichen Gehäuse 95. Der hier gezeigte Zustand entspricht der oberen Schalterstellung aus Fig. 3. Über den Drehwinkel der zweiten Kondensatorplatte 94 um die Drehachse 91 kann die Überlappung der ersten Kondensatorplatte 103 und der zweiten Kondensatorplatte 94 eingestellt werden. Der Grad der Überlappung stellt dabei die Kapazität des resultierenden Kondensators ein. Die Isolatorplatte 99 stellt dabei einen konstanten Abstand zwischen der ersten Kondensatorplatte 103 und der zweiten Kondensatorplatte 94 sicher. Über den Drehwinkel wird somit die Betriebsfrequenz eines Verstärkers, in welchem die hier gezeigte Kondensatorschaltung eingesetzt wird, eingestellt.

Wie bereits anhand von Fig. 11 - 12 dargestellt, weist auch hier das Gehäuse 95 eine Abdeckung mittels einer Leiterplatte 101 auf. Auch hier ist die Unterseite der Leiterplatte 101 mit einer Metallisierung 102 versehen. Die Erfindung ist nicht auf das dargestellt Ausführungsbeispiel beschränkt. Auch eine Umschaltung bzw. ein Umstecken verschiedener Bauelemente als dargestellt ist denkbar. Alle vorstehend beschriebenen Merkmale oder in den Figuren gezeigten Merkmale sind im Rahmen der Erfindung beliebig vorteilhaft miteinander kombinierbar.

## Patentansprüche

1. Verstärker mit einer ersten Verstärkerschaltung (16), einer zweiten Verstärkerschaltung (17), einer ersten Hybridkopplerschaltung (18) und einem Abschluss (1, 2, 3, 4, 5),
wobei die Hybridkopplerschaltung (18) über einen Ausgangsanschluss (13) und einen Isolationsanschluss (12) verfügt,
wobei der Abschluss (1, 2, 3, 4, 5) mit dem Isolationsanschluss (12) der Hybridkopplerschaltung (18) verbunden ist,
wobei der Abschluss (1, 2, 3, 4, 5) einen ersten Kondensator (30, 34, 34a, 133) und/oder eine Induktivität (35, 35a, 130) umfasst, welche unmittelbar an dem Isolationsanschluss (12) der Hybridkopplerschaltung (18) angeordnet ist, und
wobei der erste Kondensator (30, 34, 34a, 133) und/oder die Induktivität (35, 35a, 130) direkt ohne Zwischenschaltung eines Leitungselements oder nur mit einem Leitungselement, dessen Länge kleiner als 1/10der kürzesten im Verstärker verwendeten Wellenlänge ist, mit dem Isolationsanschluss (12) der Hybridkopplerschaltung (18) verbunden ist,
wobei der Abschluss (3) weiterhin einen Schalter (36) und einen Abschlusswiderstand (38) beinhaltet,
wobei der Schalter (36) an seinem Eingangsanschluss mit dem Isolationsanschluss (12) verbunden ist,
wobei der Schalter (36) an seinem ersten Ausgangsanschluss mit dem Abschlusswiderstand (38) verbunden ist und
wobei der Schalter (36) an seinem zweiten Ausgangsanschluss mit dem ersten Kondensator (30, 34, 34a, 133) und/oder der Induktivität(35, 35a, 130) verbunden ist.

2. Verstärker nach Anspruch 1,
**dadurch gekennzeichnet,**
**dass** falls der Abschluss (1, 2, 3, 4, 5) über einen ersten Kondensator (34, 34a, 133) verfügt, dieser derart ausgebildet ist, dass seine Kapazität bezüglich der Betriebsfrequenz des Verstärkers einstellbar ist.

3. Verstärker nach Anspruch 1 oder 2,
**dadurch gekennzeichnet,**
**dass** falls der Abschluss (3, 4) über eine Induktivität (35, 35a, 35b, 130) verfügt, diese derart ausgebildet, dass ihr Induktivitätswert bezüglich der Betriebsfrequenz des Verstärkers einstellbar ist.

4. Verstärker nach einem der Ansprüche 1 bis 3,
**dadurch gekennzeichnet,**
**dass** falls der Abschluss (2, 3, 5) über einen ersten Kondensator (34, 133) verfügt, dieser ein Drehkondensator oder ein Schiebekondensator, bevorzugt ein maschinell einstellbarer Drehkondensator oder ein maschinell einstellbarer Schiebekondensator, ist.

5. Verstärker nach einem der Ansprüche 1 bis 4,
**dadurch gekennzeichnet,**
**dass** der Abschluss (5) den ersten Kondensator (34a, 133), einen zweiten Kondensator (34b, 134) und die Induktivität (35b, 130) umfasst,
**dass** der erste Kondensator (34a, 133) mit dem Isolationsanschluss (12) und der Induktivität (35b, 130) verbunden ist, und
**dass** der zweite Kondensator (34b, 134) mit der Induktivität (35b, 130) verbunden ist.

6. Verstärker nach Anspruch 5,
**dadurch gekennzeichnet,**
**dass** der zweite Kondensator (34b, 134) ein Drehkondensator oder ein Schiebekondensator, bevorzugt ein maschinell einstellbarer Drehkondensator oder ein maschinell einstellbarer Schiebekondensator, ist.

7. Verstärker nach einem der Ansprüche 1 bis 6,
**dadurch gekennzeichnet,**
**dass** falls der Abschluss (3) über einen ersten Kondensator (34) verfügt, der Schalter (36) an seinem zweiten Ausgangsanschluss mit dem ersten Kondensator (34) verbunden ist, und
**dass** falls der Abschluss über eine Induktivität (35) und keinen ersten Kondensator verfügt, Schalter (36) an dem zweiten Ausgangsanschluss mit der Induktivität (35) verbunden ist.

8. Verstärker nach einem der Ansprüche 1 bis 7,
**dadurch gekennzeichnet,**
**dass** der Verstärker weiterhin über eine Steuereinrichtung (32) verfügt, welche
falls der Abschluss (2, 3, 5) über einen ersten Kondensator (34, 34a) verfügt, diesen einstellt, und/oder falls der Abschluss (5) über einen zweiten Kondensator (34b) verfügt, diesen einstellt, und/oder
falls der Abschluss (3, 4, 5) über eine Induktivität (35, 35a, 35b) verfügt, diese einstellt, und/oder falls der Abschluss (3) über einen Schalter (36) verfügt, diesen betätigt.

9. Verstärker nach Anspruch 7 oder 8,
**dadurch gekennzeichnet,**
**dass** falls der Abschluss (3) über einen Schalter (36) und einen ersten Kondensator (34) verfügt, diese durch eine Kondensatorschaltung (40) gebildet sind, und/oder dass falls der Abschluss (3) über einen Schalter und einen zweiten Kondensator verfügt, diese durch eine Kondensatorschaltung gebildet sind, und
**dass** jede Kondensatorschaltung (40) eine Kondensatorschaltung nach einem der Ansprüche 10 - 12 ist.

10. Verstärker nach einem der Ansprüche 1 bis 6,
**dadurch gekennzeichnet,**
**dass** der Verstärker über ein Verstärkergehäuse (124) und ein Einsteckmodul (120) verfügt,
**dass** das Verstärkergehäuse (124) über eine Ausnehmung (121) zur Aufnahme des Einsteckmoduls (120) verfügt,
**dass** das Einsteckmodul (120) den ersten Kondensator (133) und/oder die erste Induktivität (130) beinhaltet, und dass das Einsteckmodul (120) derart ausgebildet ist, dass es bei Einführen des Einsteckmoduls (120) in die Ausnehmung (121) in einer ersten Orientierung den ersten Kondensator (133) und/oder die erste Induktivität (130) mit dem Isolationsanschluss (12) verbindet.

11. Verstärker nach Anspruch 10,
**dadurch gekennzeichnet,**
**dass** das Einsteckmodul (120) derart ausgebildet ist, dass es bei Einführen des Einsteckmoduls (120) in die Ausnehmung (121) in einer zweiten Orientierung einen gegen Masse geschalteten ohmschen Widerstand mit dem Isolationsanschluss (12) verbindet.

12. Verstärker nach Anspruch 10 oder 11,
**dadurch gekennzeichnet,**
**dass** das Einsteckmodul (120) über Kodierungsschrauben (136) verfügt,
**dass** die Ausnehmung (121) über Federkontakte (126) verfügt,
**dass** das Einsteckmodul (120) derart ausgebildet ist, dass die Kodierungsschrauben (136) bei Einführung des Einsteckmoduls (120) in die Ausnehmung (121) Kontakt zu den Federkontakten (126) herstellen, und
**dass** die Kodierungsschrauben (136) eine gegenwärtige Abstimmfrequenz kodieren.

## Claims

1. Amplifier with a first amplifier circuit (16), a second amplifier circuit (17), a first hybrid coupler circuit (18) and a termination (1, 2, 3, 4, 5),
wherein the hybrid coupler circuit (18) has an output terminal (13) and an insulation terminal (12),
wherein the termination (1, 2, 3, 4, 5) is connected with the insulation terminal (12) of the hybrid coupler circuit (18),
wherein the termination (1, 2, 3, 4, 5) comprises a first capacitor (30, 34, 34a, 133) and/or an inductance (35, 35a, 130) which is arranged directly at the insulation terminal (12) of the hybrid coupler circuit (18), and
wherein the first capacitor (30, 34, 34a, 133) and/or the inductance (35, 35a, 130) is connected directly with the insulation terminal (12) of the hybrid coupler circuit (18), without the interposition of a line element or only with a line element the length of which is less than 1/10th of the shortest wavelength used in the amplifier,
wherein the termination (3) also comprises a switch (36) and a termination resistor (38),
wherein the switch (36) is connected at its input terminal with the insulation terminal (12),
wherein the switch (36) is connected at its first output terminal with the termination resistor (38) and
wherein the switch (36) is connected at its second output terminal with the first capacitor (30, 34, 34a, 133) and/or the inductance (35, 35a, 130).

2. Amplifier according to claim 1,
**characterised in that** if the termination (1, 2, 3, 4, 5) has a first capacitor (34, 34a, 133), this is embodied in such a way that its capacitance is adjustable with respect to the operating frequency of the amplifier.

3. Amplifier according to claim 1 or 2,
**characterised in that** if the termination (3, 4) has an inductance (35, 35a, 35b, 130), this is embodied in such a way that its inductance value is adjustable with respect to the operating frequency of the amplifier.

4. Amplifier according to one of claims 1 to 3,
**characterised in that** if the termination (2, 3, 5) has a first capacitor (34, 133), this is a rotary capacitor or a slide capacitor, preferably a rotary capacitor which is adjustable by machine or a slide capacitor which is adjustable by machine.

5. Amplifier according to one of claims 1 to 4,
**characterised in that** the termination (5) comprises the first capacitor (34a, 133), a second capacitor (34b, 134) and the inductance (35b, 130),
**in that** the first capacitor (34a, 133) is connected with the insulation terminal (12) and the inductance (35b, 130), and
**in that** the second capacitor (34b, 134) is connected with the inductance (35b, 130).

6. Amplifier according to claim 5,
**characterised in that** the second capacitor (34b, 134) is a rotary capacitor or a slide capacitor, preferably a rotary capacitor which is adjustable by machine or a slide capacitor which is adjustable by machine.

7. Amplifier according to one of claims 1 to 6,
**characterised in that** if the termination (3) has a first capacitor (34), the switch (36) is connected at its second output terminal with the first capacitor (34), and
**in that** if the termination has an inductance (35) and no first capacitor, the switch (36) is connected at the second output terminal with the inductance (35).

8. Amplifier according to one of claims 1 to 7,
**characterised in that** the amplifier also has a control unit (32) which if the termination (2, 3, 5) has a first capacitor (34, 34a) adjusts this, and/or if the termination (5) has a second capacitor (34b) adjusts this, and/or if the termination (3, 4, 5) has an inductance (35, 35a, 35b) adjusts this, and/or if the termination (3) has a switch (36) operates this.

9. Amplifier according to claim 7 or 8,
**characterised in that** if the termination (3) has a switch (36) and a first capacitor (34), these are formed by a capacitor circuit (40), and/or
**in that** if the termination (3) has a switch and a second capacitor, these are formed by a capacitor circuit, and
**in that** each capacitor circuit (40) is a capacitor circuit according to one of claims 10 to 12.

10. Amplifier according to one of claims 1 to 6,
**characterised in that** the amplifier has an amplifier housing (124) and a plug-in module (120),
**in that** the amplifier housing (124) has a recess (121) for receiving the plug-in module (120),
**in that** the plug-in module (120) comprises the first capacitor (133) and/or the first inductance (130), and
**in that** the plug-in module (120) is embodied in such a way that when the plug-in module (120) is introduced into the recess (121) in a first orientation it connects the first capacitor (133) and/or the first inductance (130) with the insulation terminal (12).

11. Amplifier according to claim 10,
**characterised in that** the plug-in module (120) is embodied in such a way that when the plug-in module (120) is introduced into the recess (121) in a second orientation it connects an ohmic resistance connected to ground with the insulation terminal (12).

12. Amplifier according to claim 10 or 11,
**characterised in that** the plug-in module (120) has coding screws (136),
**in that** the recess (121) has spring contacts (126),
**in that** the plug-in module (120) is embodied in such a way that when the plug-in module (120) is introduced into the recess (121) the coding screws make contact with the spring contacts (126), and
**in that** the coding screws (136) code a present tuning frequency.

## Revendications

1. Amplificateur comprenant un premier circuit d'amplificateur (16), un deuxième circuit d'amplificateur (17), un premier circuit coupleur hybride (18) et une terminaison (1, 2, 3, 4, 5),
dans lequel le circuit coupleur hybride (18) dispose d'une connexion de sortie (13) et d'une connexion d'isolation (12),
dans lequel la terminaison (1, 2, 3, 4, 5) est reliée à la connexion d'isolation (12) du circuit coupleur hybride (18),
dans lequel la terminaison (1, 2, 3, 4, 5) comprend un premier condensateur (30, 34, 34a, 133) et/ou une inductance (35, 35a, 130), laquelle est agencée indirectement sur la connexion d'isolation (12) du circuit coupleur hybride (18), et
dans lequel le premier condensateur (30, 34, 34a, 133) et/ou l'inductance (35, 35a, 130) sont reliés à la connexion d'isolation (12) du circuit coupleur hybride (18) directement sans interposition d'un élément conducteur ou uniquement au moyen d'un élément conducteur dont la longueur est inférieure à 1/10 de la longueur d'onde la plus courte utilisée dans l'amplificateur,
dans lequel la terminaison (3) contient en outre un commutateur (36) et une résistance de terminaison (38),
dans lequel le commutateur (36) est relié à la connexion d'isolation (12) au niveau de sa connexion d'entrée,
dans lequel le commutateur (36) est relié à la résistance de terminaison (38) au niveau de sa première connexion de sortie et
dans lequel le commutateur (36) est relié au premier condensateur (30, 34, 34a, 133) et/ou à l'inductance (35, 35a, 130) au niveau de sa deuxième connexion de sortie.

2. Amplificateur selon la revendication 1,
**caractérisé**
**en ce que** si la terminaison (1, 2, 3, 4, 5) dispose d'un premier condensateur (34, 34a, 133), ce dernier est conçu de telle manière que sa capacité peut être réglée par rapport à la fréquence de service de l'amplificateur.

3. Amplificateur selon la revendication 1 ou 2,
**caractérisé**
**en ce que** si la terminaison (3, 4) dispose d'une inductance (35, 35a, 35b, 130), celle-ci est conçue de telle manière que sa valeur d'inductance peut être réglée par rapport à la fréquence de service de l'amplificateur.

4. Amplificateur selon l'une quelconque des revendications 1 à 3,
**caractérisé**
**en ce que** si la terminaison (2, 3, 5) dispose d'un premier condensateur (34, 133), ce dernier est un condensateur rotatif ou un condensateur coulissant, de préférence un condensateur rotatif réglable mécaniquement ou un condensateur coulissant réglable mécaniquement.

5. Amplificateur selon l'une quelconque des revendications 1 à 4,
**caractérisé**
**en ce que** la terminaison (5) comprend le premier condensateur (34a, 133), un deuxième condensateur (34b, 134) et l'inductance (35b, 130),
**en ce que** le premier condensateur (34a, 133) est relié à la connexion d'isolation (12) et à l'inductance (35b, 130), et
**en ce que** le deuxième condensateur (34b 134) est relié à l'inductance (35b, 130).

6. Amplificateur selon la revendication 5,
**caractérisé**
**en ce que** le deuxième condensateur (34b, 134) est un condensateur rotatif ou un condensateur coulissant, de préférence un condensateur rotatif réglable mécaniquement ou un condensateur coulissant réglable mécaniquement.

7. Amplificateur selon l'une quelconque des revendications 1 à 6,
**caractérisé**
**en ce que** si la terminaison (3) dispose d'un premier condensateur (34), le commutateur (36) est relié au premier condensateur (34) au niveau de sa deuxième connexion de sortie, et
**en ce que** si la terminaison dispose d'une inductance (35) et ne dispose pas de premier condensateur, le commutateur (36) est relié à l'inductance (35) au niveau de la deuxième connexion de sortie.

8. Amplificateur selon l'une quelconque des revendications 1 à 7,
**caractérisé**
**en ce que** l'amplificateur dispose en outre d'un dispositif de commande (32), lequel
si la terminaison (2, 3, 5) dispose d'un premier condensateur (34, 34a), règle ce dernier, et/ou
si la terminaison (5) dispose d'un deuxième condensateur (34b), règle ce dernier, et/ou
si la terminaison (3, 4, 5) dispose d'une inductance (35, 35a, 35b), règle cette dernière, et/ou
si la terminaison (3) dispose d'un commutateur (36), actionne ce dernier.

9. Amplificateur selon la revendication 7 ou 8,
**caractérisé**
**en ce que** si la terminaison (3) dispose d'un commutateur (36) et d'un premier condensateur (34), ces derniers sont formés par un circuit de condensateur (40), et/ou
**en ce que** si la terminaison (3) dispose d'un commutateur et d'un deuxième condensateur, ces derniers sont formés par un circuit de condensateur, et
**en ce que** chaque circuit de condensateur (40) est un circuit de condensateur selon l'une quelconque des revendications 10 à 12.

10. Amplificateur selon l'une quelconque des revendications 1 à 6,
**caractérisé**
**en ce que** l'amplificateur dispose d'un boîtier d'amplificateur (124) et d'un module d'enfichage (120),
**en ce que** le boîtier d'amplificateur (124) dispose d'un évidement (121) destiné à loger le module d'enfichage (120),
**en ce que** le module d'enfichage (120) contient le premier condensateur (133) et/ou la première inductance (130), et
**en ce que** le module d'enfichage (120) est conçu de telle manière que, lors de l'introduction du module d'enfichage (120) dans l'évidement (121) dans une première orientation, relie le premier condensateur (133) et/ou la première inductance (130) à la connexion d'isolation (12).

11. Amplificateur selon la revendication 10,
**caractérisé**
**en ce que** le module d'enfichage (120) est conçu de telle manière que, lors de l'introduction du module d'enfichage (120) dans l'évidement (121) dans une deuxième orientation, il relie une résistance ohmique connectée à la masse à la connexion d'isolation (12).

12. Amplificateur selon la revendication 10 ou 11,
**caractérisé**
**en ce que** le module d'enfichage (120) dispose de vis de codage (136),
**en ce que** l'évidement (121) dispose de contacts de ressort (126),
**en ce que** le module d'enfichage (120) est conçu de telle manière que les vis de codage (136), lors de l'introduction du module d'enfichage (120) dans l'évidement (121), établissent un contact avec les contacts de ressort (126), et
**en ce que** les vis de codage (136) codent une fréquence de syntonisation actuelle.
